# EUROPÄISCHE PATENTSCHRIFT

(11) **EP 2 003 693 B1**
(45) Veröffentlichungstag und Bekanntmachung des Hinweises auf die Patenterteilung: **20.04.2011**
(21) Anmeldenummer: 08009988.0
(22) Anmeldetag: 31.05.2008
(51) Int. Cl.: H01L 25/07, H01L 23/48, H01L 23/495

(54) **Druckkontaktiertes dreiphasiges Stromrichtermodul**
Pressure contact three-phase converter module
Module de convertisseur de puissance triphasé contacté par pression

(30) Priorität: 09.06.2007 DE 102007026768
(43) Veröffentlichungstag der Anmeldung: 17.12.2008
(73) Patentinhaber: SEMIKRON Elektronik GmbH & Co. KG, 90431 Nürnberg (DE)
(72) Erfinder: Lederer, Marco, 90453 Nürnberg (DE); Popp, Rainer, 91580 Petersaurach (DE)

(56) Entgegenhaltungen:
- EP-A1- 1 467 406
- DE-C1- 10 127 947

## Beschreibung

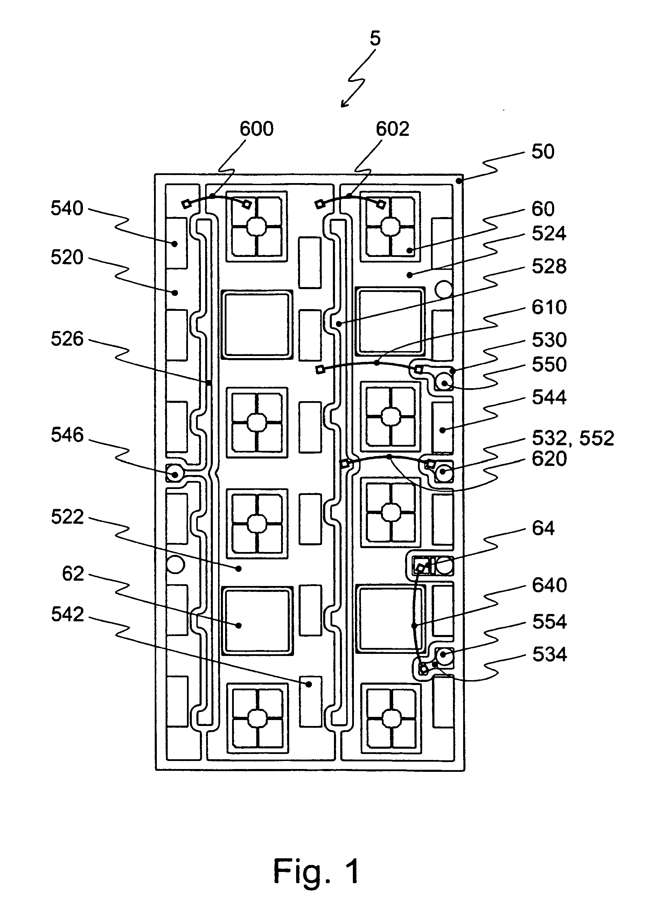

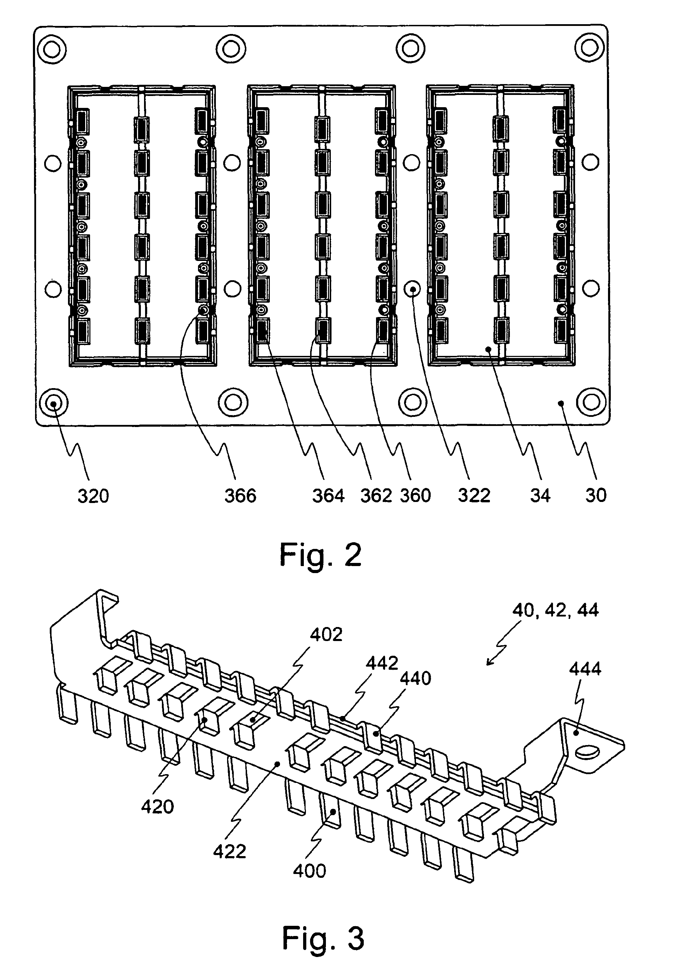

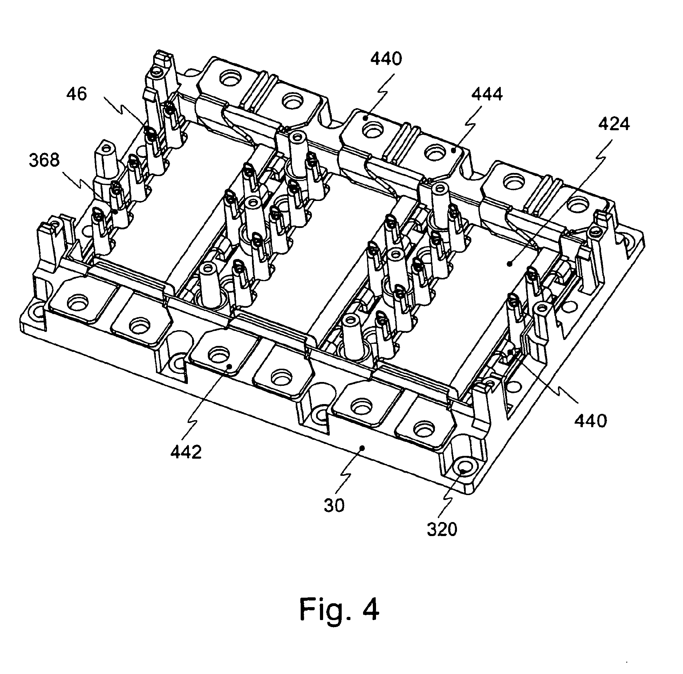

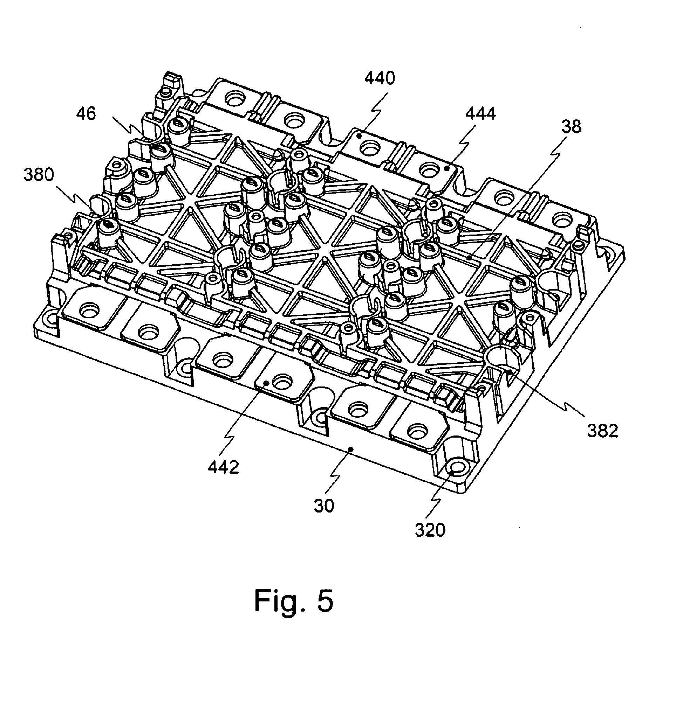

[1] Die Erfindung beschreibt ein druckkontaktiertes dreiphasiges Stromrichtermodul mit einem gemeinsamen Gehäuse und mindestens einem Substrat pro Phase zur Anordnung auf einem Kühlbauteil. Einen Ausgangspunkt der Erfindung bilden Stromrichtermodule, wie sie beispielhaft aus der DE 197 19 703 A1 bekannt sind.
[2] Derartige Stromrichtermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Stromrichtermodule Anschlusselemente für externe Last- und Hilfsanschlüsse sowie im Inneren angeordnete Verbindungselemente auf. Diese Verbindungselemente für schaltungsgerechte Verbindungen im Inneren des Stromrichtermoduls sind meist als Drahtbondverbindungen ausgebildet.
[3] Ebenfalls bekannt sind druckkontaktierte Stromrichtermodule, wie sie in der DE 42 37 632 A1, der DE 199 03 875 A1 oder der DE 101 27 947 C1 offenbart sind. Bei erstgenannter Druckschrift weist die Druckeinrichtung ein stabiles, vorzugsweise metallisches Druckelement zum Druckaufbau, ein elastisches Kissenelement zur Druckspeicherung und ein Brückenelement zur Druckeinleitung auf gesonderte Bereiche der Substratoberfläche auf. Das Brückenelement ist vorzugsweise ausgestaltet als ein Kunststoffformkörper mit einer dem Kissenelement zugewandten Fläche, von der eine Vielzahl von Druckfingern in Richtung der Substratoberfläche ausgeht.
[4] Mittels einer derartigen Druckeinrichtung wird das Substrat auf ein Kühlbauteil gedrückt und somit der Wärmeübergang zwischen dem Substrat und dem Kühlbauteil dauerhaft sicher hergestellt. Das elastische Kissenelement dient hierbei der Aufrechterhaltung konstanter Druckverhältnisse bei unterschiedlichen thermischen Belastungen und über den gesamten Lebenszyklus des Stromrichtermoduls.
[5] Die DE 199 03 875 A1 bildet das bekannte Druckelement derart weiter, dass es einerseits ein besonders vorteilhaftes Verhältnis aus Gewicht und Stabilität aufweist und andererseits elektrisch isolierte Durchführungen aufweist. Hierzu ist das Druckelement als ein Kunststoffformkörper mit innen liegender Metallseele ausgebildet. Diese Metallseele weist Ausnehmungen für die Durchführung von Anschlusselementen, vorzugsweise Hilfsanschlusselementen in Federkontaktausführung auf. Der Kunststoffformkörper umschließt diese Ausnehmungen derart, dass die Hilfsanschlusselemente mittels des Kunststoffformkörpers elektrisch von der Metallseele isoliert sind.
[6] Aus der DE 101 27 947 C1 ist ein Stromrichtermodul bekannt, wobei die Lastanschlusselemente derart ausgebildet sind, dass sie in Abschnitten eng benachbart senkrecht zur Substratoberfläche verlaufen und von dort ausgehende innere Kontakteinrichtungen, wie Kontaktfüße, aufweisen, die den elektrischen Kontakt zu den Leiterbahnen herstellen und gleichzeitig Druck auf das Substrat ausüben und somit dessen thermischen Kontakt zu einem Kühlbauteil herstellen. Der Druck wird hierbei beispielhaft mit oben genannten Mitteln nach dem Stand der Technik eingeleitet. Die EP 1467406 A1 offenbart ein Leistungshalbleitermodul mit nach außen führenden Last- und Hilfsanschlußelementen.
[7] Der Erfindung liegt die Aufgabe zugrunde ein dreiphasiges Stromrichtermodul in Druckkontaktausführung vorzustellen, wobei Hilfs- und Lastanschlusselemente besonders geeignet zueinander angeordnet sind.
[8] Die Aufgabe wird erfindungsgemäß gelöst durch die Maßnahmen der Merkmale des Anspruchs 1. Bevorzugte Ausführungsformen sind in den Unteransprüchen beschrieben.
[9] Der erfinderische Gedanke geht aus von einem dreiphasigen Stromrichtermodul in Druckkontaktausführung zur Anordnung auf einem Kühlbauteil mit mindestens einem Substrat je Phase, pro Substrat mindestens einem Leistungshalbleiterbauelement, beispielhaft bipolaren Transistoren, einem Gehäuse mit Druckdeckel und nach außen führenden Last- und Hilfsanschlusselementen. Jedes Substrat weist einen Isolierstoffkörper auf und auf dessen erster, dem Inneren des Stromrichtermoduls zugewandten Hauptfläche Leiterbahnen mit Lastpotential. Weiterhin weist das Substrat Leiterbahnen mit Hilfspotential zur Ansteuerung der Leistungshalbleiterbauelemente, oder auch zum Anschluss von Sensorbauteilen auf.
[10] Das Stromrichtermodul weist weiterhin Lastanschlusselemente jeweils ausgebildet als Metallformkörper mit äußeren und inneren Kontakteinrichtungen und einem bandartigen Abschnitt auf. Die jeweiligen bandartigen Abschnitte der einzelnen Lastanschlusselemente sind vorzugsweise parallel zur Substratoberfläche und von dieser beabstandet angeordnet. Die inneren Kontakteinrichtungen, sog. Kontaktfüße, die von dem bandartigen Abschnitt ausgehen, reichen zum Substrat und bilden dort schaltungsgerecht die Kontakte der Lastanschlüsse aus. Vorzugsweise kontaktieren sie hierzu auf dem Substrat die Leiterbahnen mit Lastpotential, alternativ auch direkt die Leistungshalbleiterbauelemente.
[11] Erfindungsgemäß sind die Hilfsanschlusselemente als Kontaktfedern ausgebildet, wobei diese zugeordnete zweite Kontaktflächen von Leiterbahnen mit Hilfspotential des Substrats in dessen Randbereich kontaktieren und hierbei ausschließlich in Zwischenräumen von zwei der drei ebenfalls im Randbereich angeordneten Reihen der Kontaktfüße angeordnet sind.
[12] Die erfinderische Lösung wird an Hand eines Ausführungsbeispiels in verschiedenen Darstellungen gemäß den Fig. 1 bis 5 weiter erläutert.
[13] Fig. 1 zeigt ein Substrat einer Phase eines erfindungsgemäßen Stromrichtermoduls.
[14] Fig. 2 zeigt ein Gehäuse über den Substraten des Stromrichtermoduls.
[15] Fig. 3 zeigt die Lastanschlusselemente des Stromrichtermoduls in dreidimensionaler Ansicht..
[16] Fig. 4 zeigt die Anordnung von Hilfs- und Lastanschlusselementen im Gehäuse des Stromrichtermoduls in dreidimensionaler Ansicht..
[17] Fig. 5 zeigt das Stromrichtermodul mit Deckel in dreidimensionaler Ansicht.
[18] Das erfindungsgemäße Stromrichtermodul weist pro Phase ein Substrat (5) gemäß Fig. 1 auf. Dieses Substrat (5) weist einen isolierenden Grundkörper (50) sowie Leiterbahnen (520, 522, 524, 526, 528, 530, 532, 534) mit verschiedenen Potentialen auf. Bekannte Substrate dieser Ausprägung sind beispielhaft AMD- (active metal braze), DCB-(direct copper bonding) oder IMS- (insulated metal substrat) Substrate.
[19] Auf Leiterbahnen mit Lastpotential (520, 522, 524) sind die Leistungshalbleiterbauelemente, beispielhaft Leistungstransistoren (60) und Leistungsdioden (62), des Stromrichtermoduls angeordnet und schaltungsgerecht mit weiteren Leiterbahnen verbunden. Vorzugsweise sind diese Verbindungen als schematisch dargestellte Drahtbondverbindungen (600, 602, 610) ausgebildet. Hierzu zählten Lastverbindungen (600, 602) mit weiteren Lastpotential führenden Leiterbahnen sowie Hilfsverbindungen wie Steuerverbindungen mit Hilfs-, hier Steuerpotential führenden Leiterbahnen (526, 528).
[20] In der dargestellten Ausgestaltung verlaufen in Längsrichtung des Substrats (5) die Leiterbahnen mit den Lastpotentialen positiver (524), negativer Polarität (520) sowie diejenige mit Wechselpotential (522). Weiterhin dargestellt sind die Leiterbahnen mit dem Steuerpotential (526, 528) der ersten und zweiten Leistungshalbleiterbauelemente, sowie diejenigen Leiterbahnen (534), die der elektrischen Verbindung eines auf dem Substrat (5) angeordneten Temperatursensors (64) dienen.
[21] Die ersten (540, 542, 544) und zweiten (546, 550, 554) Kontaktflächen zu den Last- und Hilfsanschlusselementen gemäß Fig. 4 sind in Fig. 1 ebenfalls gekennzeichnet. Die ersten Kontaktflächen des positiven (524), des negativen (520) Potentials sowie des Wechselpotentials (520) liegen in Längsrichtung des Substrats (5) in Reihe angeordnet. Die zweiten Kontaktflächen (546, 550, 554) mit Hilfspotential sind hier ausschließlich in Zwischenräumen der ersten Kontaktflächen (540, 542, 544) mit Lastpotential angeordnet, die im Randbereich des Substrats (5) liegen. Hier sind dies die Zwischenräume zwischen den Kontaktflächen (540, 544) des positiven und des negativen Potentials.
[22] Für eine derartige Ausgestaltung ist es hier notwendig, eine mittig längs auf dem Substrat angeordnete Leiterbahn (528) mit Steuerpotential mittels einer Bondverbindung (620) mit einer Leiterbahn (532) im Randbereich zu verbinden. Diese Leiterbahn weist dann die zugeordnete Kontaktfläche (552) zur Verbindung mit einem Hilfsanschlusselement auf. In ebensolcher Weise ist eine Leiterbahn (530) mit zugeordneter Kontaktfläche (550) mit einer Leiterbahn (522) mit Wechselpotential mittels einer Drahtbondverbindung (620) verbunden.
[23] Das Sensorbauteil, hier ein chipförmiger Temperatursensor (64), ist auf einer eigenen Leiterbahn (534) mit einer zugehörigen Kontaktfläche (554) angeordnet und mit einer weiteren Leiterbahn mit ebenfalls zugehöriger Kontaktfläche mittels einer Drahtbondverbindung (640) verbunden. Auch diese beiden Kontaktflächen sind erfindungsgemäß angeordnet.
[24] Fig. 2 zeigt das Gehäuse (30) des Stromrichtermoduls aus Sicht des nicht dargestellten Substrats (5). Dieses Gehäuse (5) ist derart ausgebildet, dass es die einzelnen Substrate gemäß Fig. 1 mittels einer Zwischenlage (34) überdeckt. Diese Zwischenlage ist derart ausgebildet, dass die Kontaktelemente (400, 420, 440, 46; vgl. Fig. 3 und 4) der Hilfs- und Lastanschlusselement durch diese Zwischenlage hindurch reichen können. Hierzu weist die Zwischenlage (34) rechteckig ausgebildete Schächte (360, 362, 364) für die Kontaktfüße (400, 420, 440) der Lastanschlusselemente (40, 42, 44) und rund ausgebildete Schächte (366) für die als Kontaktfedern (46, vgl. Fig. 4) ausgebildeten Hilfsanschlusselemente auf. In Fig. 4 ist dargestellt, wie diese Hilfs- und Lastanschlusselemente aus Sicht in Richtung der Substrate (5) im Gehäuse (30) gemäß Fig. 2 angeordnet sind.
[25] Die Lastanschlusselemente (40, 42, 44) werden hierbei gemäß Fig. 3 gebildet als ein Stapel von drei Metallformkörpern, einem je Phase. Jeder dieser Metallformkörper weist gemäß Fig. 4 äußere Kontakteinrichtungen (404, 424, 444) zur Schraubverbindung mit Zuleitungen, einem bandartigen Abschnitt (402, 422, 442) und mit von diesem ausgehend in drei Reihen angeordnete Kontaktfüßen (400, 420, 440) auf. Diese sind derart ausgebildet, dass sie durch die rechteckigen Schächte (360, 362, 364) der Zwischenlage (34) des Gehäuses (30) zum Substrat (5) reichen und dort zugeordnete erste Kontaktflächen 540, 542, 544), vgl. Fig. 1, von Leiterbahnen (520, 522, 524) mit Lastpotential schaltungsgerecht kontaktieren.
[26] Ebenfalls dargestellt in Fig. 4 sind die Hilfsanschlusselemente, ausgebildet als Kontaktfedern (34). In einer Mehrzahl von Zwischenräumen zwischen den Kontaktfüßen (440, 444) des Lastanschlusselements (40, 44, vgl. Fig. 3) positiver, bzw. negativer Polarität sind die Steueranschlusselemente angeordnet. In weiteren Zwischenräumen zwischen den Kontaktfüßen (444) des Lastanschlusselements (44) negativer Polarität sind ebenso die Hilfsanschlusselemente, identisch zu den übrigen als Kontaktfedern ausgebildet, zur Verbindung des Temperatursensors (64) angeordnet. All diese Kontaktfedern (46) sind in Schächten mit zusätzlichen zur Führung der Kontaktfeder ausgebildeten Domen (368) angeordnet.
[27] Das erfindungsgemäße Stromrichtermodul weist weiterhin eine Druckkontakteinrichtung bestehend aus einem nicht dargestellten Druckspeicher und einem Druck einleitenden Druckelement (38) auf. Dieses Druckelement ist hier gleichzeitig als Deckel des Gehäuses in Fig. 4 dargestellt. Der Druckspeicher ist hierbei auf dem Stapel aus Lastanschlusselementen (40, 42, 44) angeordnet um alle Kontaktfüße (400, 420, 440) gleichmäßig auf die zugeordneten Kontaktflächen (540, 542, 544) der Leiterbahnen (520, 522, 524) des Substrats (5) zu drücken.
[28] Hierdurch wird einerseits der elektrische Kontakt zwischen den Lastanschlusselementen (40, 42, 44) und den Leiterbahnen (520, 522, 524) des Substrats (5) hergestellt anderseits der thermische Kontakt des Substrats (5) zu einem nicht dargestellten Kühlbauteil. Hierzu weist der Druck einleitende Druckdeckel (38) Ausnehmungen (382) für Schraubverbindungen mit dem Kühlbauteil auf, die auch durch das Gehäuse (30) hindurch reichen. Der Druck wird hierbei auf den Druckspeicher übertragen, welcher ihn weiter auf die bandartigen Abschnitte (402, 422, 442) der Lastanschlusselemente (40, 42, 44) und somit auf deren Kontaktfüße (400, 420, 440) überträgt.
[29] Mittels des Druckdeckels (38) werden die Kontaktfedern (46) einerseits ebenfalls auf die zugeordneten Kontaktflächen (550, 552, 554) gedrückt und somit dauerhaft sicher kontaktiert. Anderseits sind die Ausnehmungen (380) derart ausgestaltet, dass sie eine verliersichere Durchführung der Hilfsanschlusselemente (46) bilden.
[30] Damit diese Druckeinleitung auf die bandartigen Abschnitte (402, 422, 442) möglichst homogen erfolgen kann, sind erfindungsgemäß alle Hilfsanschlusselemente (46) aus dem mittleren Bereich des Substrats (5) in dessen Randbereich verlegt. Hierdurch ist es möglich einerseits den Druck auf alle Kontaktfüße (400, 420, 440) gleichmäßig einzuleiten und somit deren elektrischen Kontakt gleichmäßig auszubilden, wodurch die elektrische Leistung des Stromrichtermoduls verbessert wird. Anderseits wird auf diese Weise auch der thermische Kontakt zwischen Substrat (5) und Kühlbauteil, der ebenfalls über die Kontaktfüße (400, 420, 440) eingeleitet wird, homogen ausgebildet. Dadurch kann die Verlustwärme der Leistungshalbleiterbauelemente (60, 62) gleichmäßig abgeführt werden, was hauptsächlich der Lebensdauer des Stromrichtermoduls zugute kommt.

## Patentansprüche

1. Druckkontaktiertes dreiphasiges Stromrichtermodul, mit mindestens einem Substrat (5) mit Leistungshalbleiterbauelementen (60, 62) pro Phase, mit einem Gehäuse (30), einem Druckelement (38) und nach außen führenden Last- (40, 42, 44) und Hilfsanschlusselementen (46),
wobei das jeweilige Substrat (5) einen Isolierstoffkörper (50) aufweist und auf dessen erster dem Inneren des Stromrichtermoduls zugewandten Hauptfläche Leiterbahnen (520, 522, 524, 526, 528) mit Last- und Hilfspotentialen angeordnet sind,
wobei die Lastanschlusselemente (40, 42, 44) je Phase jeweils als Metallformkörper mit äußeren Kontakteinrichtungen (404, 424, 444) einem bandartigen Abschnitt (402, 422, 442) und mit von diesem ausgehenden in drei Reihen angeordneten Kontaktfüßen (400, 420, 440) ausgebildet sind, die zum Substrat (5) reichen und dort erste Kontaktflächen (540, 542, 544) von Leiterbahnen (520, 522, 524) mit Lastpotential schaltungsgerecht kontaktieren, und
wobei die Hilfsanschlusselemente (46) als Kontaktfedern ausgebildet sind, diese zugeordnete zweite Kontaktflächen (546, 550, 554) von Leiterbahnen (526, 530, 534) mit Hilfspotential des Substrats (5) in dessen Randbereich kontaktieren und hierbei ausschließlich in Zwischenräumen von zwei der drei ebenfalls im Randbereich angeordneten Reihen der Kontaktfüße (400, 440) angeordnet sind.

2. Stromrichtermodul (1) nach Anspruch 1,
wobei die Leiterbahnen (520, 522, 524) mit Lastpotential des jeweiligen Substrats (5) und hierauf die Leistungshalbleiterbauelemente (60, 62) in Längsrichtung des Substrats (5) angeordnet sind und die Kontaktfüße (400, 440) der Lastanschlusselemente (40, 44) positiven und negativen Potentials im Randbereich des Substrats (5) angeordnet sind.

3. Stromrichtermodul (1) nach Anspruch 1,
wobei auf dem Substrat (5) die Leiterbahnen (530, 532, 534) der zweiten Kontaktflächen (530, 532, 534) für Hilfsanschlusselemente (46) mit weiteren Leiterbahnen (522, 528) des Substrats (5) mittels Drahtbondverbindungen 610, 620) verbunden sind.

4. Stromrichtermodul (1) nach Anspruch 1,
wobei die Lastanschlusselemente (40, 42, 44) im Bereich der bandartigen Abschnitte (402, 422, 442) einen Stapel bilden.

5. Stromrichtermodul (1) nach Anspruch 1,
wobei zwischen dem Druckelement (38) und den bandartigen Abschnitten (402, 422, 442) der Lastanschlusselemente (40, 42, 44) jeder Phase je ein elastischer Druckspeicher angeordnet ist.

6. Stromrichtermodul (1) nach Anspruch 1,
wobei das Druckelement (38) Ausnehmungen (380) zur verliersicheren Durchführung der Hilfsanschlusselemente (46) aufweist.

## Claims

1. Pressure contacted three phase power converter module with at least one substrate (5) with power semiconductor components (60, 62) per phase, with a housing (30), a pressure element (38) and load (40, 42, 44) and auxiliary connection elements (46) leading outside,
wherein the respective substrate (5) has an insulant body (50) and conductor tracks (520, 522, 524, 526, 528) with load and auxiliary potentials are arranged on its first main surface facing the interior of the power converter module,
wherein the load connection elements (40, 42, 44) are constructed per phase as shaped metal bodies with external contact devices (404, 424, 444), a strip-like section (402, 422, 442) and contact feet (400, 420, 440) arranged in three rows emanating therefrom, which reach as far as the substrate (5) and there contact first contact surfaces (540, 542, 544) of conductor tracks (520, 522, 524) with load potential appropriately for the circuit, and
wherein the auxiliary connection elements (46) are constructed as contact springs, these contact assigned second contact surfaces (546, 550, 554) of conductor tracks (526, 530, 534) with auxiliary potential of the substrate (5) in its edge region, and are here arranged exclusively in intermediate spaces of two of the three rows of the contact feet (400, 440) likewise arranged in the edge region.

2. Power converter module (1) according to Claim 1,
wherein the conductor tracks (520, 522, 524) with load potential of the respective substrate (5) and hereupon the power semiconductor components (60, 62) are arranged in the longitudinal direction of the substrate (5) and the contact feet (400, 440) of the load connection elements (40, 44) of positive and negative potential are arranged in the edge region of the substrate (5).

3. Power converter module (1) according to Claim 1,
wherein on the substrate (5), the conductor tracks (530, 532, 534) of the second contact surfaces (530, 532, 534) for auxiliary connection elements (46) are connected to further conductor tracks (522, 528) of the substrate (5) by means of wire bond connections (610, 620).

4. Power converter module (1) according to Claim 1,
wherein the load connection elements (40, 42, 44) form a stack in the region of the strip-like sections (402, 422, 442).

5. Power converter module (1) according to Claim 1,
wherein one elastic pressure accumulator is in each case arranged between the pressure element (38) and the strip-like sections (402, 422, 442) of the load connection elements (40, 42, 44) of each phase.

6. Power converter module (1) according to Claim 1,
wherein the pressure element (38) has recesses (380) for loss-proof leading through of the auxiliary connection elements (46).

## Revendications

1. Module convertisseur triphasé mis en contact par pression, comprenant au moins un substrat (5) avec des composants à semi-conducteurs de puissance (60, 62) par phase, un boîtier (30), un élément de pression (38) et des éléments de charge (40, 42, 44) et des éléments de raccordement auxiliaire (46) allant vers l'extérieur,
le substrat (5) concerné présentant un corps isolant (50) et des pistes conductrices (520, 522, 524, 526, 528) avec des potentiels de charge et des potentiels auxiliaires étant disposées sur la première surface principale, tournée vers l'intérieur du module convertisseur, de ce corps,
les éléments de raccordement de charge (40, 42, 44) étant conçus par phase à chaque fois sous forme de corps moulés métalliques avec des dispositifs de contact extérieurs (404, 424, 444), une partie (402, 422, 442) en forme de bande et des pieds de contact (400, 420, 440) disposés sur trois rangées à partir de cette partie, lesquels pieds vont jusqu'au substrat (5) et mettent en contact ici des premières surfaces de contact (540, 542, 544) de pistes conductrices (520, 522, 524) avec du potentiel de charge de façon adaptée en commutation, et
les éléments de raccordement auxiliaire (46) étant conçus sous forme de ressorts de contact, lesquels mettent en contact des secondes surfaces de contact (546, 550, 554) associées de pistes conductrices (526, 530, 534) avec le potentiel auxiliaire du substrat (5) dans la zone périphérique de celui-ci, et sont disposés exclusivement dans des espaces intermédiaires de deux des trois rangées, disposées également dans la zone périphérique, des pieds de contact (400, 440).

2. Module convertisseur (1) selon la revendication 1,
les pistes conductrices (520, 522, 524) avec le potentiel de charge du substrat (5) respectif et par-dessus les composants à semi-conducteurs de puissance (60, 62) étant disposées dans le sens de la longueur du substrat (5) et les pieds de contact (400, 440) des éléments de raccordement de charge (40, 44) de potentiel positif et négatif étant disposés dans la zone périphérique du substrat (5).

3. Module convertisseur (1) selon la revendication 1,
les pistes conductrices (530, 532, 534) des secondes surfaces de contact (530, 532, 534) pour des éléments de raccordement auxiliaire (46) étant reliées sur le substrat (5) avec d'autres pistes conductrices (522, 528) du substrat (5) au moyen de connexions par liaison à fil (610, 620).

4. Module convertisseur (1) selon la revendication 1,
les éléments de raccordement de charge (40, 42, 44) formant une pile dans la zone des parties (402, 422, 442) en forme de bande.

5. Module convertisseur (1) selon la revendication 1,
un accumulateur de pression élastique étant disposé à chaque fois entre l'élément de pression (38) et les parties (402, 422, 442) en forme de bande des éléments de raccordement de charge (40, 42, 44) de chaque phase.

6. Module convertisseur (1) selon la revendication 1,
l'élément de pression (38) présentant des évidements (380) pour le passage sans perte des éléments de raccordement auxiliaire (46).
